# EUROPÄISCHE PATENTSCHRIFT

(11) **EP 3 050 739 B1**
(45) Veröffentlichungstag und Bekanntmachung des Hinweises auf die Patenterteilung: **05.01.2022**
(21) Anmeldenummer: 15003248.0
(22) Anmeldetag: 13.11.2015
(51) Int. Cl.: B60L 58/13, B60L 58/16, B60L 58/24, G01R 31/24, G01R 31/392, G01R 31/44, H01M 10/42, B60L 3/12, H02J 7/00, H01M 10/48

(54) **VERFAHREN UND VORRICHTUNG ZUR STEUERUNG UND/ODER REGELUNG MINDESTENS EINES EINEN ALTERUNGSZUSTAND EINES ELEKTRISCHEN ENERGIESPEICHERS BEEINFLUSSENDEN BETRIEBSPARAMETERS DES ELEKTRISCHEN ENERGIESPEICHERS**
METHOD AND DEVICE FOR CONTROLLING AND/OR REGULATING AT LEAST ONE OPERATING PARAMETER OF THE ELECTRICAL ENERGY STORAGE DEVICE WHICH AFFECTS AN AGING STATE OF AN ELECTRICAL ENERGY STORAGE DEVICE
PROCEDE ET DISPOSITIF DE COMMANDE ET/OU DE REGLAGE D'AU MOINS UN PARAMETRE DE FONCTIONNEMENT INFLUENÇANT UN ETAT DE VIEILLISSEMENT D'UN SYSTEME DE STOCKAGE ENERGETIQUE ELECTRIQUE

(30) Priorität: 29.01.2015 DE 102015001050
(43) Veröffentlichungstag der Anmeldung: 03.08.2016
(73) Patentinhaber: MAN Truck & Bus SE, 80995 München (DE)
(72) Erfinder: Kratzer, Sebastian, 80997 München (DE); Kirchensteiner, Elmar, 85256 Vierkirchen (DE); Müller, Bernd, 81375 München (DE)
(74) Vertreter: v. Bezold & Partner Patentanwälte - PartG mbB

(56) Entgegenhaltungen:
- WO-A1-2007/048366
- DE-A1-102009 042 656
- DE-A1-102011 005 711
- US-A1- 2011 313 613
- US-A1- 2013 027 048
- None

## Beschreibung

Die Erfindung betrifft ein Verfahren und eine Vorrichtung zur Steuerung und/oder Regelung mindestens eines einen Alterungszustand eines elektrischen Energiespeichers eines Kraftfahrzeugs beeinflussenden Betriebsparameters des elektrischen Energiespeichers.

Elektrische Energiespeicher, insbesondere Traktionsbatterien bzw. Hochvoltbatterien von Mildhybrid-, Hybrid- oder Elektrofahrzeugen, unterliegen diversen Alterungseffekten und sollten im Hinblick auf die Alterungseffekte auf eine geplante Lebensdauer, vorzugsweise der geplanten Produktlebensdauer des Kraftfahrzeugs, ausgelegt sein.

Im Bereich der Kraftfahrzeugtechnik ist es zur Überwachung des Betriebszustandes und der Alterungseffekte des elektrischen Energiespeichers bekannt, aus den aktuellen Betriebsgrößen des elektrischen Energiespeichers, insbesondere der Spannung, dem Strom und der Temperatur des elektrischen Energiespeichers den Ladezustand (engl. state of charge (SOC)) oder den Alterungszustand (engl. state of health (SOH)) des elektrischen Energiespeichers zu berechnen. Verfahren zur Ermittlung des Alterungszustandes von Fahrzeugbatterien sind beispielsweise aus der US 6,103,408, DE 197 50 309 A oder der DE 37 12 629 C2, DE 100 49 495 A bekannt. Ein Verfahren zur Vorhersage einer Restlebensdauer eines elektrischen Energiespeichers ist beispielsweise aus der DE 103 28 721 A1 bekannt.

Insbesondere ist aus der Praxis bekannt, dass die Alterung des elektrischen Energiespeichers von der Temperatur, Strombelastung und Zyklisierung beeinflusst wird. Im Stand der Technik wird daher versucht, eine Beschädigung des elektrischen Energiespeichers durch Festlegen vorbestimmter zulässiger Bereiche für diese Betriebsparameter des elektrischen Energiespeichers zu vermeiden.

Zur Begrenzung der temperaturbedingten Alterung ist es aus dem Stand der Technik, beispielsweise der DE 10 2007 063 178.A1, DE 10 2007 010 751 A1 oder WO 2010/121831 A1, bekannt, dass derartige Hochvolt-Batterien mittels eines Kühlsystems und fluiddurchströmten Kühlplatten temperiert werden, um eine entstehende Verlustwärme abzuführen, damit der zulässige Betriebsbereich für die Temperatur des elektrischen Energiespeichers nicht verletzt wird.

Aus der Praxis ist ferner bekannt, elektrische Energiespeicher durch einen Über- und Unterladeschutz oder durch Spannungsbegrenzung vor zu starker Belastung und somit zu schneller Alterung zu schützen.

Aus der Offenlegungsschrift WO 2007/048366 A1 ist ein Verfahren zur Steuerung des Arbeitspunktes einer Batterie bekannt, bei dem als eine den Arbeitspunkt der Batterie bestimmte Zustandsgröße der Ladezustand der Batterie erfasst wird, wobei der aktuelle Arbeitspunkt mittels eines zugehörigen, in Abhängigkeit von der Temperatur und/oder vom Alterungszustand fortlaufend angepassten Soll-Wert für den Ladezustand eingestellt wird. Aus der Offenlegungsschrift DE 10 2009 042 656 A1 ist ein Verfahren zur Steuerung mindestens eines den Halterungszustand eines elektrischen Energiespeichers beeinflussenden Betriebsparameters des elektrischen Energiespeichers bekannt, wobei ein tatsächlicher Alterungszustand des Energiespeichers ermittelt wird, der mit einem für das momentane Alter des Energiespeichers vorgegebenen Soll-Alterungszustand verglichen wird. Nachfolgend kann eine Einschränkung eines für den mindestens einen Betriebsparameter zugelassenen Betriebsparameterbereichs erfolgen, wenn der tatsächliche Alterungszustand schlechter als der Soll-Alterungszustand ist.

Nachteilig an den bekannten Ansätzen ist jedoch, dass die Alterung elektrischer Energiespeicher auch bei Einhaltung solch fest vorgegebener Betriebsbereiche für die Betriebsparameter des Energiespeichers im tatsächlichen Betrieb, z. B. je nach individueller Beanspruchung, Fahrverhalten und Einsatzort des Fahrzeugs, sehr unterschiedlich verlaufen und damit von dem geplanten Alterungsverlauf abweichen kann.

Es ist somit eine Aufgabe der Erfindung, ein verbessertes Betriebsverfahren für einen elektrischen Energiespeicher eines Kraftfahrzeugs bereitzustellen, mit dem Nachteile herkömmlicher Betriebsverfahren vermieden werden können. Die Aufgabe der Erfindung ist es insbesondere, ein Betriebsverfahren für einen elektrischen Energiespeicher bereitzustellen, mit dem eine zu starke Abweichung von der geplanten Lebensdauer des Energiespeichers und insbesondere ein Ausfall oder vorzeitiger Austausch des elektrischen Energiespeichers aufgrund von Alterungseffekten vor Ablauf der geplanten Lebensdauer vermieden werden kann. Eine weitere Aufgabe ist es, eine Vorrichtung zur Regelung und/oder Steuerung des elektrischen Energiespeichers bereitzustellen, mit der Nachteile herkömmlicher Vorrichtungen vermieden werden können.

Diese Aufgaben werden durch Vorrichtungen und Verfahren mit den Merkmalen der unabhängigen Ansprüche gelöst. Vorteilhafte Ausführungsformen und Anwendungen der Erfindung sind Gegenstand der abhängigen Ansprüche und werden in der folgenden Beschreibung unter teilweiser Bezugnahme auf die Figuren näher erläutert.

Gemäß einem ersten Gesichtspunkt der Erfindung werden die genannten Aufgaben durch ein Verfahren zur Steuerung und/oder Regelung mindestens eines einen Alterungszustand eines elektrischen Energiespeichers eines Kraftfahrzeugs beeinflussenden Betriebsparameters des elektrischen Energiespeichers gelöst.

Gemäß dem Verfahren wird ein tatsächlicher Alterungszustands SOH_{Ist} des elektrischen Energiespeichers überwacht und bestimmt sowie ein Soll-Alterungszustands SOH_{Soll} des elektrischen Energiespeichers bestimmt. Der Soll-Alterungszustands SOH_{Soll} ist hierbei durch eine definierte Alterungskurve über die Zeit vorgegeben. Erfindungsgemäß wird dann ein zugelassener Betriebsparameterbereich für den mindestens einen Betriebsparameter angepasst, wenn ein Vergleich des tatsächlichen Alterungszustands SOH_{Ist} mit dem Soll-Alterungszustand SOH_{Soll} ergibt, dass der tatsächliche Alterungszustand eine erhöhte Alterung und/oder eine geringere Alterung im Vergleich zum Soll-Alterungszustand SOH_{Soll} anzeigt. Bei einer festgestellten erhöhten Alterung wird der Betriebsparameterbereich so angepasst, dass der Betrieb des elektrischen Energiespeichers innerhalb des angepassten Betriebsparameterbereichs mit verringerter Alterungsgeschwindigkeit erfolgt, so dass eine Rückführung auf die Soll-Alterungskurve erreicht wird oder sich der tatsächliche Alterungszustands SOHₗₛₜ der Soll-Alterungskurve zumindest annähert.

Die Erfindung umfasst also die allgemeine technische Lehre, den tatsächlichen Alterungszustand SOHₗₛₜ des elektrischen Energiespeichers zu überwachen und bei einer Verschlechterung des tatsächlichen Alterungszustands SOHₗₛₜ im Vergleich zu einem für das momentane Lebensalter des Energiespeichers erwarteten Soll-Alterungszustand SOH_{Soll} den zulässigen Betriebsparameterbereich eines oder mehrerer die Alterung des Energiespeichers beeinflussenden Betriebsparameter so anzupassen, dass der Energiespeicher bis zum Ende seiner vorgegebenen Soll-Lebensdauer funktionsfähig bleibt. Hierbei dient die relative Abweichung des tatsächlichen Alterungszustands SOHₗₛₜ vom erwarteten Soll-Alterungszustand SOH_{Soll} als Eingangsgröße für einen Regler oder eine Steuerung, welche(r) in Abhängigkeit der relativen Abweichung den zulässigen Wertebereich eines oder mehrerer den Alterungszustand des Energiespeichers beeinflussenden Betriebsparameter verändert, um eine Annäherung von SOH_{Ist} als Regelgröße zu SOH_{Soll} als Führungsgröße zu bewirken.

Wenn ein Vergleich des tatsächlichen Alterungszustands SOH_{Ist} mit dem Soll-Alterungszustand SOH_{Soll} ergibt, dass der tatsächliche Alterungszustand eine verringerte Alterung im Vergleich zum Soll-Alterungszustand SOH_{Soll} anzeigt, wird der Betriebsparameterbereich so angepasst, dass der Betrieb des elektrischen Energiespeichers innerhalb des angepassten Betriebsparameterbereichs mit erhöhter Alterungsgeschwindigkeit erfolgt, so dass auch in diesem Fall eine Rückführung auf die Soll-Alterungskurve erreicht wird oder sich der tatsächliche Alterungszustands SOHₗₛₜ der Soll-Alterungskurve zumindest annähert.

Gemäß dieser Variante wird der Betriebsparameterbereich des mindestens einen Betriebsparameters somit nicht nur bei einer festgestellten zu schnellen, sondern auch bei einer zu langsamen Alterung angepasst. Dies bietet den Vorteil, dass der oder die Betriebsparameterbereiche zur Erhöhung der Leistungsfähigkeit des Energiespeichers angepasst werden, bis der tatsächliche Alterungszustands SOH_{Ist} wieder dem basierend auf der momentanen Lebensdauer des Energiespeichers erwarteten Soll-Alterungszustand SOH_{Soll} entspricht.

Eine erhöhte und/oder verringerte Alterung kann festgestellt werden, wenn der Differenzbetrag aus tatsächlichem Alterungszustand (SOH_{Ist}) und Soll-Alterungszustand (SOH_{Soll}) einen vorbestimmten Schwellenwert überschreitet. Der Schwellenwert kann auf den Wert Null festgelegt werden, so dass bei jeder Abweichung ein Anpassen des für den mindestens einen Betriebsparameter zugelassenen Betriebsparameterbereichs erfolgt.

Besonders vorteilhaft ist jedoch eine Festlegung des Schwellenwerts auf einen zweckmäßig festgelegten Wert größer Null, so dass erst bei einer Mindestabweichung eingegriffen und der zulässige Wertebereich für den mindestens einen Betriebsparameter angepasst wird. Ferner können für die Feststellung der erhöhten und die Feststellung der verringerten Alterung jeweils unterschiedliche Schwellenwerte festgelegt werden.

Der Begriff "elektrischer Energiespeicher", nachfolgend auch kurz als Energiespeicher bezeichnet, umfasst insbesondere Traktionsbatterien bzw. Hochvoltbatterien für Mildhybrid-, Hybrid- oder Elektrofahrzeuge. Unter einer Traktionsbatterie bzw. einer Hochvoltbatterie wird eine Batterie bzw. ein Batteriepack zur Bereitstellung von elektrischer Energie für einen reinen elektromotorischen Antrieb oder zumindest einen elektromotorisch unterstützen Antrieb eines als Mildhybrid-, Hybrid- oder Elektrofahrzeug ausgeführten Kraftfahrzeugs verstanden.

Für den Begriff "Alterungszustand", auch als Gebrauchstüchtigkeit bezeichnet, wird üblicherweise und insbesondere in diesem Dokument auch der englischen Ausdruck "State of Health" bzw. das entsprechende Akronym "SOH" verwendet.

Verfahren zum Bestimmen des tatsächlichen Alterungszustand SOH_{Ist} sind, wie eingangs erwähnt, aus dem Stand der Technik bekannt. Hierbei wird der Alterungszustand üblicherweise in Prozent angegeben, ausgehend von einem Ausgangszustand von 100%, bei dem der Energiespeicher seine volle Leistungsfähigkeit aufweist, bis zum einem Endzustand, der mit 0% angeben wird. 0% bedeutet in diesem Zusammenhang, dass der Energiespeicher gerade noch eine vorgegebene Mindestleistungsfähigkeit aufweist, beispielweise 80% der ursprünglichen Leistungsfähigkeit, und nicht, dass er überhaupt nicht mehr funktionsfähig ist. Der Ausgangszustand wir auch als "Beginning of Life"-Zustand bzw. BoL-Zustand und der Endzustand auch als End of Life bzw. EoL-Zustand bezeichnet. Nach Erreichen des EoL-Zustandes von 0% sollte der Energiespeicher ausgetauscht werden.

Erfindungsgemäß umfasst das Verfahren ferner ein Bestimmen einer Restlebensdauer (engl. remaining mission time) des elektrischen Energiespeichers, bis dieser voraussichtlich den EoL-Zustand erreicht. Erfindungsgemäß erfolgt das Anpassen des für den mindestens einen Betriebsparameter zugelassenen Betriebsparameterbereichs in Abhängigkeit von der bestimmten Restlebensdauer, derart, dass die Anpassung mit abnehmender Restlebensdauer größer ist.

Dies bietet den Vorteil, dass die Stärke der Anpassung des Betriebsparameterbereichs, z. B. die Stärke des Reglereingriffs, automatisch an die Zeit (Restlebensdauer) angepasst wird, die noch zum Ausgleichen der Abweichung zwischen Ist-Alterungszustand SOH_{Ist} und Soll-Alterungszustand SOH_{Soll} verbleibt. Anstatt der Restlebensdauer kann analog auch die Restnutzungsstrecke (engl. remaining mission distance) verwendet werden.

Diese Restlebensdauer wird als Zeit bis zum Erreichen beliebig festlegbarer Grenzwerte für die Mindestleistung oder Mindestspeicherfähigkeit festgelegt, also die voraussichtliche Dauer bis zum Erreichen des EoL-Zustands. Die Restlebensdauer wird üblicherweise durch Extrapolation mit Hilfe eines mathematischen Modells des Energiespeichers ermittelt, vgl. z. B. die DE 103 28 721 A1. Alternativ kann gemäß einer Variante dieser Ausgestaltungsform statt der Restlebensdauer auch die Restnutzungsstrecke angegeben werden, d. h. beispielsweise die Kilometeranzahl, die mit dem Energiespeicher noch gefahren werden kann, bis dieser den EoL-Zustand erreicht.

Gemäß einem vorteilhaften Ausführungsbeispiel gibt der mindestens eine Betriebsparameter ein zulässiges Ladezustandsfenster (State of Charge (SOC)-Fenster) des elektrischen Energiespeichers an, das eine zulässige untere Ladezustandsgrenze SOC_{Min} und eine zulässige obere Ladezustandsgrenze SOC_{Max} festlegt. Die untere Ladezustandsgrenze SOC_{Min} gibt beispielsweise an, wie tief der Energiespeicher maximal entladen werden darf. Gemäß diesem Ausführungsbeispiel wird die zulässige untere Ladezustandsgrenze SOC_{Min} angehoben und/oder die zulässige obere Ladezustandsgrenze SOC_{Max} abgesenkt, wenn der tatsächliche Alterungszustand eine erhöhte Alterung im Vergleich zum Soll-Alterungszustand SOH_{Soll} anzeigt, d. h., wenn die Differenz aus Soll-Alterungszustand SOH_{Soll} und tatsächlichem Alterungszustands SOHₗₛₜ einen vorbestimmten Schwellenwert überschreitet.

Durch eine Absenkung der zulässigen oberen Ladezustandsgrenze SOC_{Max} und/oder durch ein Anheben der zulässigen unteren Ladezustandsgrenze SOC_{Min} verringert sich zwar die effektiv zur Verfügung stehende, vom Energiespeicher bereitstellbare Energiemenge, jedoch verringert sich bei kleineren Energiehüben bekanntermaßen auch die Speicherdegradierung und Alterungsgeschwindigkeit. Bei einer Variante dieses Ausführungsbeispiels besteht im Rahmen der Erfindung die Möglichkeit, die zulässige obere Ladezustandsgrenze SOC_{Max} zu erhöhen und/oder die zulässige untere Ladezustandsgrenze SOC_{Min} zu verringern, wenn der tatsächliche Alterungszustand eine verringerte Alterung im Vergleich zum Soll-Alterungszustand SOH_{Soll} anzeigt.

Gemäß einem weiteren Ausführungsbeispiel gibt der mindestens eine Betriebsparameter einen maximal zulässigen Lade- und/oder Entladestrom oder einen maximal zulässigen Lade- und/oder Entladestrom für ein parametrierbares Zeitintervall an. Gemäß dieser Ausführungsvariante wird der maximal zulässige Lade- und/oder Entladestrom abgesenkt, wenn der tatsächliche Alterungszustand SOH_{Ist} eine erhöhte Alterung im Vergleich zum Soll-Alterungszustand SOH_{Soll} anzeigt. Gemäß diesem Ausführungsbeispiel wird somit die Beschränkung der Leistungszufuhr oder -entnahme bzw. die Leistungszufuhr oder -entnahme pro Zeitintervall als Stellgröße verwendet, um die Alterungseffekte zu beeinflussen, da eine reduzierte Leistungszufuhr oder -entnahme auch die Speicherdegradierung und Alterungsgeschwindigkeit reduziert.

Ferner besteht im Rahmen der Erfindung wieder die Möglichkeit, den maximal zulässigen Lade- und/oder Entladestrom bzw. den maximal zulässigen Lade- und/oder Entladestrom pro Zeitintervall anzuheben, wenn der tatsächliche Alterungszustand eine verringerte Alterung im Vergleich zum Soll-Alterungszustand SOH_{Soll} anzeigt

Gemäß einem weiteren Ausführungsbeispiel gibt der mindestens eine Betriebsparameter eine obere Temperaturgrenze für die maximal zulässige Temperatur des Energiespeichers an. Gemäß dieser Ausführungsvariante wird die obere Temperaturgrenze abgesenkt, wenn der tatsächliche Alterungszustand eine erhöhte Alterung im Vergleich zum Soll-Alterungszustand (SOH_{Soll}) anzeigt, und/oder die obere Temperaurgrenze wird erhöht, wenn der tatsächliche Alterungs-zustand eine verringerte Alterung im Vergleich zum Soll-Alterungszustand (SOH_{Soll}) anzeigt.

Die vorgenannten Ausführungsbeispiele sind kombinierbar, so dass z. B. das Ladefenster, die Stromgrenzen und die obere Temperaturgrenze gleichzeitig und/oder abwechselnd angepasst werden können.

Der Soll-Alterungszustand SOH_{Soll} gibt den für das momentane Lebensalter des Energiespeichers erwarteten Alterungszustand des Energiespeichers an. Der Soll-Alterungszustand SOH_{Soll} kann mittels einer hinterlegten Kennlinie bestimmt werden, die einen Soll-Alterungszustand SOH_{Soll} in Abhängigkeit von einem ersten Parameter, der ein Maß für eine Dauer seit der Inbetriebnahme des elektrischen Energiespeichers ist, und/oder von einem zweiten Parameter, der ein Maß für den bisherigen Energiedurchsatz des elektrischen Energiespeichers ist, angibt.

Gemäß einem weiteren bevorzugten Ausführungsbeispiel wird anhand von Daten, die einen bisherigen zeitlichen Verlauf des tatsächlichen Alterungszustands SOH_{Ist} des Energiespeichers angeben, der sich durch Anpassung der Betriebsparameterbereiche wenigstens zweier Betriebsparameter ergeben hat, derjenige Betriebsparameter ermittelt, der durch Anpassung seines Betriebsparameterbereichs am schnellsten eine Annäherung des tatsächlichen Alterungszustands SOH_{Ist} hin zum Soll-Alterungszustand SOH_{Soll} ermöglicht hat. Mit anderen Worten kann das Verfahren gemäß diesem Aspekt "lernen", welcher Betriebsparameter sich am effektivsten als Stellgröße für die gewünschte Reduzierung der Abweichung von SOH_{Ist} hin zum Soll-Alterungszustand SOH_{Soll} eignet. Der so ermittelte Betriebsparameter kann dann bevorzugt zur Steuerung bzw. Regelung verwendet werden.

Gemäß einer Weiterbildung der Erfindung besteht die Möglichkeit, dass bei einer Abweichung des tatsächlichen Alterungszustands (SOH_{Ist}) vom Soll-Alterungszustand (SOH_{Soll}) des elektrischen Energiespeichers ein zukünftiger Verlauf des tatsächlichen Alterungszustands (SOH_{Ist}) auf Basis von gespeicherten Nutzungsdaten des elektrischen Energiespeichers vorhergesagt wird, wobei die Anpassung des für den mindestens einen Betriebsparameter zugelassenen Betriebsparameterbereichs in Abhängigkeit von dem vorhergesagten zukünftigen Verlauf des tatsächlichen Alterungszustands (SOH_{Ist}) erfolgt.

Die gespeicherten Nutzungsdaten können beispielsweise Stromprofile der bisherigen Nutzung im Form von Lastkollektiven angeben. Ein zulässiger Strombereich des Energiespeichers von z. B. 0 bis 100 A kann hierbei in einzelne Klassen, z. B. 0 bis 10A, 10 bis 20A, ...90 bis 100A, aufgeteilt werden, so dass gespeicherte Daten des Lastkollektivs angeben, wie oft bzw. wie lange welche Stromklasse im bisherigen Betrieb des Energiespeichers genutzt wurde und wie sich die Nutzung der verschiedenen Stromklassen auf den tatsächlichen Alterungszustand ausgewirkt haben, was z. B. durch korrespondierende Nutzungsdaten, die eine Veränderung des Innenwiderstands angeben, bestimmt werden kann. Mit anderen Worten kann das Verfahren gemäß diesem Aspekt "lernen", wie sich ein bestimmtes Nutzungsprofil des Energiespeichers auf dessen Alterung auswirkt, um daraufhin seine Betriebsparameter zu optimieren. Wiederholt sich ein Nutzungsprofil im aktuellen Betrieb, kann anhand der gespeicherten Nutzungsdaten bzw. Nutzungshistorie die Auswirkung auf den Alterungszustand des Energiespeichers abgeschätzt bzw. vorausgesagt werden. Wird auf diese Weise der weitere Verlauf einer Abweichung des tatsächlichen Alterungszustands (SOH_{Ist}) vom Soll-Alterungszustands (SOH_{Soll}) des elektrischen Energiespeichers abgeschätzt, kann dies bei der Anpassung eines Betriebsparameterbereichs berücksichtigt werden. Beispielsweise kann die Größe der Anpassung des Betriebsparameterbereichs umso größer gewählt werden, desto größer der geschätzte Verlauf der Abweichung des tatsächlichen Alterungszustands (SOH_{Ist}) vom Soll-Alterungszustands (SOH_{Soll}) unter Verwendung der Nutzungsdaten ist.

Die Nutzungsdaten können auch den bisherigen Energiedurchsatz pro Zeit umfassen.

Gemäß einer weiteren Weiterbildung der Erfindung besteht die Möglichkeit, dass das Anpassen eines für den mindestens einen Betriebsparameter zugelassenen Betriebsparameterbereichs durch eine Simulation erfolgt. Die Simulation verwendet ein Lebensdauerenergiespeichermodell und ein vorgegebenes Lebensdauernutzungsprofil des Energiespeichers und berechnet eine Entwicklung des tatsächlichen Alterungszustands (SOH_{Ist}) in Abhängigkeit davon, welche Betriebsparameterbereichsanpassung welches Betriebsparameters vorgenommen wird. Anhand der Simulation kann dann vorausberechnet werden, welche Anpassung eines Betriebsparameterbereiches und/oder welcher Betriebsparameter eine optimale Annäherung an den Soll-Alterungszustands (SOH_{Soll}) ermöglicht. Dadurch kann iterativ das optimale Betriebsgrößenset ermittelt werden, welches auf Basis des vorgegebenen Soll-Alterungsverhaltens und eines angenommenen Nutzungsverhaltens eine optimal Speichernutzung ermöglicht.

Gemäß einem zweiten Gesichtspunkt der Erfindung werden die genannten Aufgaben durch eine Vorrichtung zur Steuerung und/oder Regelung mindestens eines einen Alterungszustand eines elektrischen Energiespeichers eines Kraftfahrzeugs beeinflussenden Betriebsparameters des elektrischen Energiespeichers gelöst, die ausgeführt ist, das Verfahren wie hierin offenbart auszuführen.

Zur Vermeidung von Wiederholungen sollen rein verfahrensgemäß offenbarte Merkmale auch als vorrichtungsgemäß offenbart gelten und beanspruchbar sein.

Gemäß einer bevorzugten Ausgestaltungsform umfasst die Vorrichtung eine erste Steuereinrichtung zur Steuerung der Antriebsstrangkomponenten des Kraftfahrzeugs, die insbesondere auch festlegt, inwieweit die elektrische Maschine zum geforderten Antriebsmoment beiträgt und entsprechend den Inverter der elektrischen Maschine ansteuert; und eine zweite Steuereinrichtung zur Steuerung des elektrischen Energiespeichers.

Hierbei ist die erste Steuereinrichtung ausgeführt, den Soll-Alterungszustand SOH_{Soll} des elektrischen Energiespeichers zu bestimmen und an die zweite Steuereinrichtung zu übertragen; einen angepassten Betriebsparameterbereich des wenigstens einen Betriebsparameters des elektrischen Energiespeichers von der zweiten Steuereinrichtung zu empfangen und unter Berücksichtigung des empfangenen Betriebsparameterbereichs wenigstens eines Betriebsparameters des elektrischen Energiespeichers einen Inverter des elektrischen Energiespeichers anzusteuern.

Hierbei ist die zweite Steuereinrichtung ausgeführt, den tatsächlichen Alterungszustands SOH_{Ist} des elektrischen Energiespeichers zu bestimmen, den bestimmten Soll-Alterungszustand SOH_{Soll} von der ersten Steuereinrichtung zu empfangen und den zugelassenen Betriebsparameterbereich für den mindestens einen Betriebsparameter anzupassen und an die erste Steuereinrichtung zu übertragen.

Die Erfindung betrifft ferner ein Kraftfahrzeug, vorzugsweise ein Nutzfahrzeug, mit einer Steuervorrichtung wie hierin offenbart.

Die zuvor beschriebenen bevorzugten Ausführungsformen und Merkmale der Erfindung sind beliebig miteinander kombinierbar. Weitere Einzelheiten und Vorteile der Erfindung werden im Folgenden unter Bezug auf die beigefügten Zeichnungen beschrieben. Es zeigen:
- Figur 1: einen Regelverlauf des tatsächlichen Alterungszustands SOH_{Ist} im Vergleich zum Soll-Alterungszustand SOH_{Soll} des elektrischen Energiespeichers; und
- Figur 2: ein schematisches Blockdiagramm zur Illustration einer Vorrichtung gemäß einer Ausführungsform der Erfindung und zur Illustration des Verfahrens gemäß einer Ausführungsform der Erfindung.

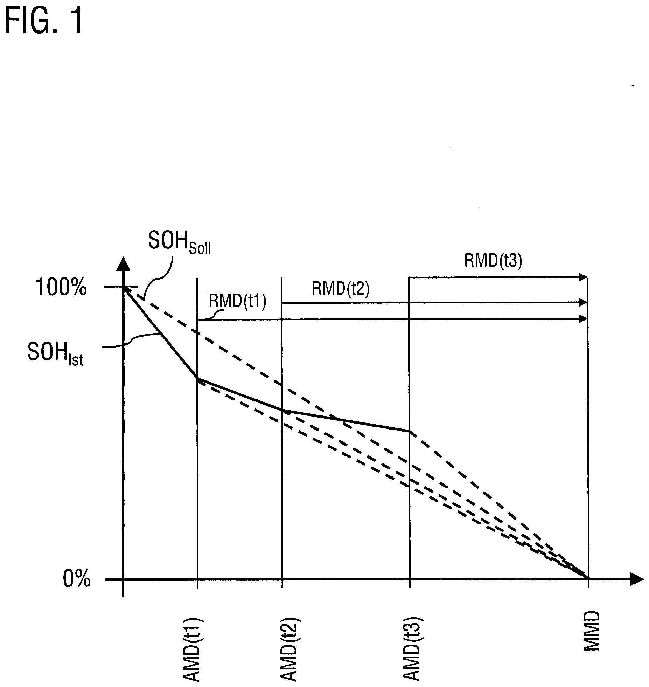

Figur 1 zeigt einen Verlauf des geregelten tatsächlichen Alterungszustands SOHₗₛₜ über die Nutzungsstrecke des Energiespeichers im Vergleich zum Soll-Alterungszustand SOH_{Soll} des elektrischen Energiespeichers.

Die mit SOH_{Soll} gekennzeichnete gepunktete Linie beschreibt die zulässige Soll-Alterung des Energiespeichers in Abhängigkeit von der zurückgelegten Nutzungsstrecke bzw. Fahrstrecke, bei der der elektrische Energiespeicher im Betrieb war (engl. mission distance). Ausgehend von einem Ausgangszustand von 100%, bei dem der Energiespeicher seine volle Leistungsfähigkeit aufweist, altert der Energiespeicher, d. h., seine Leistungsfähigkeit sinkt auf einen Alterungszustand "EoL" von 0%, wie vorstehend bereits beschrieben. In diesem Zustand ist der Energiespeicher zwar noch funktionsfähig, sollte aber zeitnah ausgetauscht werden. Die zurücklegbare Nutzungsstrecke von Inbetriebnahme bis zum Erreichen des Alterungszustands 0% sollte mindestens die Soll-Nutzungsstrecke (engl. maximum mission distance (MMD)) betragen, für die der Energiespeicher entsprechend ausgelegt wurde.

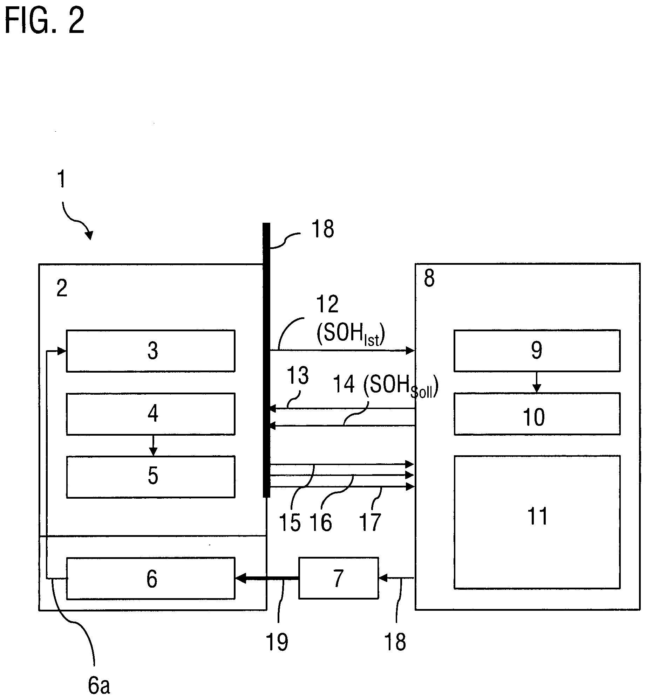

Der Verlauf der gepunkteten Linie stellt eine Kennlinie dar, die im Speicher einer nachfolgend noch im Zusammenhang von Figur 2 beschriebenen Reglervorrichtung hinterlegt ist. Die Kennlinie SOH_{Soll} wird beispielsweise in Abhängigkeit von einem Lastkollektiv, d. h. einem geschätzten Stromprofil, mit dem der elektrische Energiespeicher bei typischen Fahrzyklen über seine Lebensdauer belastet wird, vorab bestimmt. In Abhängigkeit von dieser Kennlinie legt der Batteriehersteller den elektrischen Energiespeicher aus. Wird der elektrische Energiespeicher im tatsächlichen Fahrbetrieb mit einem ähnlichen Lastkollektiv belastet, verläuft die tatsächliche Alterung des elektrischen Energiespeichers SOH_{Ist} wie die Soll-Alterung SOH_{Soll} gemäß Kennlinie.

In der Regel kommt es im tatsächlichen Fahrbetrieb zu davon abweichenden Strombelastungen des Energiespeichers, so dass die tatsächliche Alterung SOHₗₛₜ des Energiespeichers schneller oder langsamer als die Kennlinie SOH_{Soll} erfolgt. Die tatsächliche Alterung SOH_{Ist} des Energiespeichers ist in Figur 1 mit der durchgezogenen Linie dargestellt.

An den verschiedenen Auswertezeitpunkten t1, t2, und t3, werden die jeweils verbleibenden Restnutzungsstrecken RMD(t1), RMD(t2) und RMD(t3) berechnet, die sich aus der Differenz von Soll-Nutzungsstrecke (MMD) und der jeweiligen bisherigen Nutzungsstrecke AMD(t1), AMD(t2) und AMD(t3) ergeben.

An den verschiedenen Auswertezeitpunkten t1, t2, und t3 wird der tatsächliche Alterungszustands SOH_{Ist} des elektrischen Energiespeichers bestimmt. Ferner wird für den aktuellen Wert der Restnutzungsstrecke RMD(t) unter Verwendung der Kennlinie der Soll-Alterungszustand SOH_{Soll} des elektrischen Energiespeichers im Punkt RMD(t) bestimmt.

Anstatt der zurückgelegten Nutzungsstrecke könnte auf der Abszisse auch die Zeit aufgetragen werden. Der maximalen Nutzungsstrecke entspräche dann die Soll-Lebensdauer (engl. maximum mission time). Anstatt der jeweils verbleibenden Restnutzungsstrecken RMD(t1), RMD(t2) und RMD(t3) würde dann jeweils die an den Auswertezeitpunkten verbleibende Nutzungsdauer (remaining mission time) berechnet.

Weicht der tatsächliche aktuelle Alterungszustands SOHₗₛₜ vom bestimmten Soll-Alterungszustands SOH_{Soll} um mehr als einen vorbestimmten Schwellenwert ab, werden die Stellwerte der Stellgrößen angepasst. Als Stellgrößen dienen Betriebsparameter des Energiespeichers, die dessen Alterung beeinflussen, insbesondere das zulässige Ladezustandsfenster des elektrischen Energiespeichers (SOC-Fenster) und die maximal zulässigen Lade-und/oder Entladeströme des Energiespeichers und die maximal zulässigen Lade- und/oder Entladeströme pro Zeitintervall. Als Sollwerte werden die zulässigen Betriebsparameterbereiche dieser Betriebsparameter so angepasst, dass die angepassten Betriebsparameterbereiche zu einer Verkleinerung der Abweichung des tatsächlichen aktuellen Alterungszustands SOH_{Ist} zum Soll-Alterungszustands SOH_{Soll} führen.

In den Zeitpunkten t1 und t2 wird z. B. festgestellt, dass der Energiespeicher im Vergleich zur Kennlinie SOH_{Soll} zu schnell gealtert ist, folglich wird beispielsweise das zulässige Ladezustandsfenster an diesen Punkten verkleinert. Beispielsweise kann die untere Ladezustandsgrenze (SOCMin), die die minimale Endladetiefe der Nennkapazität angibt, z. B. 20%, angehoben werden, und/oder die obere Ladezustandsgrenze (SOCMax) kann abgesenkt werden.

Ferner kann der maximal zulässige Lade- und/oder Entladestrom für ein parametrierbares Zeitintervall, d. h. der maximale Strom, der dem Energiespeicher über einen bestimmten Zeitraum entnommen werden darf, auf einen kleineren Wert festgelegt werden, um die Alterung zu verlangsamen.

Im Punkt t3 wird gemäß Figur 1 dagegen festgestellt, dass der Prozentwert des aktuellen Alterungszustands SOH_{Ist} größer ist als der Soll-Alterungszustands SOH_{Soll}, d. h., der Energiespeicher ist langsamer gealtert als gemäß Kennlinie vorhergesehen. Folglich wird beispielsweise das zulässige Ladezustandsfenster an diesen Punkten vergrößert und/oder die maximal zulässigen Lade- und Entladeströme erhöht, wodurch die Leistungsfähigkeit des Energiespeichers erhöht und dessen Alterung beschleunigt wird.

Die Stellwerte der Stellgrößen werden dabei so gewählt, dass die Abweichung des SOH_{Ist} zum SOH_{Soll} bei Erreichen der Soll-Nutzungsstrecke (MMD) ausgeregelt ist, was durch die gestrichelten Linien in Figur 1 dargestellt ist. Wie in Figur 1 zu sehen ist, müssen die Stellgrößen - und damit die Limitierung der zulässigen Bereiche der Batterie-Betriebsparameter - hin zum Endpunkt der Soll-Nutzungsstrecke MMD immer schärfer ausgeführt werden, da der Regler immer weniger Zeit zum Ausregeln hat. Je kleiner somit die Restnutzungsstrecke oder die verbleibende Lebensdauer ist, desto stärker ist der Reglereingriff.

Die gestrichelten Figuren stellen somit ausgehend von dem jeweiligen Auswertezeitpunkt einen fiktiven Sollverlauf des tatsächlichen Alterungszustands dar. Da jedoch z. B. ausgehend vom Zeitpunkt t1 der tatsächliche Verlauf von SOH_{Ist} gemäß der durchgezogenen Linie von der gestrichelten abweicht, findet im Punkt t2 eine erneute Anpassung der Stellgrößen statt.

Figur 2 zeigt beispielhaft ein schematisches Blockdiagramm zur Illustration eines Ausführungsbeispiels eines Reglers zur Ausbildung eines Regelkreises, um den aktuellen Alterungszustands SOH_{Ist} des Energiespeichers als Regelgröße auf den Soll-Alterungszustands SOH_{Soll} als Führungsgröße einzuregeln.

Mit dem Bezugszeichen 1 ist eine Traktionsbatterie eines Kraftfahrzeugs bezeichnet, die in an sich bekannter Weise einen Batteriepack 6 aus einer Mehrzahl von Einzelzellen umfasst. Die Batterie umfasst ferner eine Steuereinheit 2. Mit dem Bezugszeichen 8 ist eine Fahrzeugsteuerung zur Steuerung der Antriebsstrangkomponenten (Verbrennungsmotor, Kupplung, elektrische Antriebsmaschine, etc.) des Kraftfahrzeugs bezeichnet. Insbesondere werden hier unter Berücksichtigung der zulässigen Betriebsgrößen der Batterie die Vorgaben 18 für den Inverter 7 der elektrischen Antriebsmaschine gebildet.

Die Steuereinheit 2 der Traktionsenergie und die Fahrzeugsteuerung 8 bilden den Regler eines Regelkreises zur Regelung des tatsächlichen Alterungszustands der Batterie 1 auf den Soll-Alterungszustand. Die beiden Steuereinheiten tauschen für die benötigte Größen über den CAN-Datenbus 18 aus, was schematisch durch die schwarzen Pfeile in Figur 2 dargestellt ist.

Hierzu ist die Steuereinheit 2 in an sich bekannter Weise eingerichtet, mit einer SOH_{Ist}-Berechnungseinheit 3 fortlaufend oder regelmäßig den aktuellen tatsächlichen Alterungszustand (State of Health) SOH_{Ist} der Batterie als Regelgröße zu bestimmen, wofür die SOH_{Ist}-Berechnungseinheit 3 entsprechende Strom- und Spannungsmesswerte von dem Batteriepack 6 über die Signalleitung 6a übermittelt bekommt.

Die Fahrzeugsteuerung 8 weist eine Berechnungseinheit 10 auf, die korrespondierend zu den Berechnungszeitpunkten für den SOH_{Ist} der Batterie jeweils den aktuellen Soll-Alterungszustand SOH_{Soll} als Führungsgröße bestimmt. Im Normalfall wird der SOH_{Soll} nach der oben genannten Kennlinie berechnet, indem die Fahrzeugsteuerung die aktuell verbleibende Restnutzungsstrecke (remaining mission distance) oder die aktuelle Restlebensdauer (remaining mission time) berechnet und den zugehörigen Soll-Alterungszustands SOH_{Soll} gemäß Kennlinie bestimmt. Die aktuelle Restlebensdauer kann beispielsweise aus der Differenz zwischen Soll-Lebensdauer und der bisherigen Dauer seit der Fahrzeugproduktion bestimmt werden.

Die Fahrzeugsteuerung 8 hat allerdings optional die Möglichkeit, Sondereffekte mit zu berücksichtigen. Steht das Fahrzeug z. B. längere Zeit ohne Benutzung, altert die Batterie dennoch (kalendarische Alterung). Die SOH-Sollvorgabe kann dann von der Kennlinie abweichen. Hierzu kann der bestimmte tatsächlichen Alterungszustand SOH_{Ist} von der Steuereinheit 2 an die Fahrzeugsteuerung 8 geschickt werden (Pfeil 12) und von dieser in einer weiteren Berechnungseinheit 9 zur Berechnung eines Offsets des aktuellen Soll-Alterungszustands SOH_{Soll} verwendet werden. Die Berechnungseinheit 9 greift hierbei auf Nutzungsdaten des bisherigen Fahrzeugbetriebsverhaltens zu.

Der bestimmte tatsächliche Alterungszustand SOH_{Ist} sowie die berechnete aktuell verbleibende Restnutzungsstrecke RMD oder Restlebensdauer werden der Batteriesteuereinheit 2 übermittelt (dargestellt durch die Pfeile 13 und 14).

Aus der Differenz von SOH_{Ist} und SOH_{Soll} der Batterie berechnet die Steuereinheit 2 angepasste Betriebsparameterbereiche als Stellwert für die Energiespeicherbetriebsgrößen (Stellgrößen), die die Alterung des Energiespeichers 1 maßgeblich beeinflussen.

Hierzu erfolgt in einer ersten Berechnungseinheit 4 zuerst eine Analyse, bei der anhand von Daten des zeitlichen Verlaufs des tatsächlichen Alterungszustands (SOH_{Ist}) in Abhängigkeit von der Anpassung der Betriebsparameterbereiche derjenige Betriebsparameter ermittelt wird, der durch Anpassung seines Betriebsparameterbereichs am schnellsten eine Annäherung des tatsächlichen Alterungszustands (SOHₗₛₜ) hin zum Soll-Alterungszustand (SOH_{Soll}) ermöglicht. Mit anderen Worten erfolgt hierbei eine Auswertung der SOH-Änderung bei gegebenen Batterie-Betriebsgrößen, also beispielsweise des SOC-Ladefensters und der Grenzen für die maximal zulässigen Lade- und/oder Entladeströme im Rahmen einer "Online-Adaption" des SOH-Reglers 2, 8. So kann der SOH-Regler 2, 8 aus bisherigen Daten "lernen", welche Änderung der Stellgröße (SOC-Ladefenster oder zulässige Lade- und/oder Entladeströme) am effektivsten zu der gewünschten Reduzierung des Regelfehlers führt.

Hierbei sind optional mehrere Weiterbildungsmöglichkeiten der Regelung denkbar. Über einen deterministisch abgeleiteten Entscheidungsbaum und unter Berücksichtigung der SOH-Abweichung werden die Betriebsgrößen linear angepasst und Maßnahmen zur Anpassung der Betriebsparameterbereiche wie SOC-Fenster, Stromgrenzen und Temperaturbereiche miteinander kombiniert oder sequentiell angewendet. Ferner könnte mittels eines Verfahrens, mit welchem der Speicher seine bisherige Nutzungshistorie analysiert, und bei Vorliegen einer SOH Abweichung selbständig die weitere Alterung auf Basis der Historiendaten prognostiziert und daraufhin die Betriebsparameter des Energiespeichers optimiert werden. Gemäß einer weiteren Weiterbildung könnte der Speicher verschiedene Sets an möglichen Betriebsparametern selbständig durchsimulieren und somit iterativ das optimale Betriebsgrößenset ermitteln, welches auf Basis des Kundenverhaltens und der SOH-Vorgabe die maximale Speichernutzung ermöglicht.

Die Berechnungseinheit 4 überträgt das Ergebnis in Form des oder der zu verwendeten Betriebsparameter als Stellgrößen an eine Berechnungseinheit 5, die dann angepasste zulässige Wertebereiche für die Betriebsparameter berechnet. Bei geringer Regelabweichung zwischen SOHₗₛₜ und SOH_{Soll} wird die Berechnungseinheit 5 die Betriebsgrößen wenig oder gar nicht anpassen.

Die von der Fahrzeugsteuerung 8 übermittelte Restnutzungsstrecke RMD oder Restlebensdauer gibt hierbei an, wieviel Zeit noch zum Ausregeln bleibt. Je kürzer die Restnutzungsstrecke RMD oder Restlebensdauer ist, desto stärker muss der Regeleingriff sein, so dass die Restnutzungsstrecke RMD oder Restlebensdauer bei der Festlegung der Stärke der Anpassung der Betriebsparameterbereiche berücksichtigt wird.

Die Berechnungseinheit 5 berechnet beispielsweise geänderte Werte für die zulässige untere Ladezustandsgrenze SOC_{Min} und die zulässige obere Ladezustandsgrenze SOC_{Max} und übermittelt die Werte an die Fahrzeugsteuerung 8 (dargestellt durch Pfeil 17). Die Berechnungseinheit 5 berechnet beispielsweise ferner die fortan zulässigen Wertebereiche für die maximal zulässigen Entlade- und Ladeströme des Energiespeichers 1 und die maximal zulässigen Entlade- und Ladespannungen und übermittelt die angepassten Werte ebenfalls an die Fahrzeugsteuerung 8 (dargestellt durch die Pfeil 15 und 16).

Die empfangenen Werte werden von einem Steuermodul 11 der Fahrzeugsteuerung 8 verwendet, das ein Fahrmoment von den verschiedenen Antrieben anfordert. Das Steuermodul 8 fordert nun ein entsprechendes Moment von der elektrischen Maschine über deren Inverter 7 an (dargestellt durch Pfeil 18), jedoch unter Einhaltung der angepassten zulässigen Wertebereiche für Batteriebetriebsparameter. Entsprechend wird vom Inverter 7 ein Batteriestrom 19 von dem Batteriepack 6 unter Einhaltung der angepassten zulässigen Wertebereiche für Batteriebetriebsparameter angefordert. Mit einer erneuten Bestimmung des aktuellen tatsächlichen Alterungszustands (State of Health) SOHₗₛₜ beginnt der Regelkreis von Neuem.

Das Steuermodul 11 hat als Ziel, das Kraftstoff-Einsparpotential zu maximieren, was in der Regel mit einem verstärkten Einsatz der elektrischen Maschine und damit der Traktionsbatterie 1 einhergeht. Das Steuermodul 11 wird daher bei geringer Limitierung der Batterie-Betriebsgrößen die elektrische Antriebsmaschine und damit die Traktionsbatterie 1 verstärkt einsetzen. Der verstärkte Einsatz wird zu einer beschleunigten Alterung der Batterie führen, woraufhin die Batterie den entstehenden Regelfehler durch Limitierung der Batterie-Betriebsgrößen ausregelt. Die einzige Stellgröße des Steuermoduls 11 ist der Einsatz der elektrischen Maschine, was sich direkt in dem von der Traktionsbatterie 1 angeforderten Batteriestrom 19 auswirkt. Der angeforderte Batteriestrom 19 darf dabei die von der Batterie gemeldeten Betriebsgrößen nicht überschreiten. Der angeforderte Batteriestrom 19 darf somit nur so hoch gewählt werden, dass das von der Batterie gemeldete SOC-Fenster nicht verlassen wird. Erfindungsgemäß wird somit eine selbstregulierende Regelstrecke bereitgestellt, die sicherstellt, dass Betriebsweise und Alterung des Energiespeichers sich selbst regulieren, um einen Betrieb innerhalb der Auslegungsgrenzen bis zum Ablauf der Solllebensdauer sicherzustellen.

Der Schutzumfang der Erfindung ist durch die Ansprüche definiert.

### Bezugszeichenliste

- 1: Elektrischer Energiespeicher
- 2: Steuerung des elektrischen Energiespeichers
- 3: SOH_{Ist}-Berechnungseinheit
- 4: Berechnungseinheit
- 5: Betriebsparameterbereichberechnungseinheit
- 6: Batteriepack
- 6a: Signalleitung
- 7: Inverter
- 8: Fahrzeugsteuerung
- 9: Berechnungseinheit
- 10: SOH_{Soll}- und Restlebensdauerberechnungseinheit
- 11: Steuermodul
- 12: Übermittlung des berechneten SOH_{Ist}
- 13: Übertragung der Restlebensdauer
- 14: Übertragung von SOH_{Soll}
- 15-17: Übertragung der angepassten Betriebsparameterbereiche
- 18: Inverteransteuersignal
- 19: Batteriestrom

## Patentansprüche

1. Verfahren zur Steuerung und/oder Regelung mindestens eines einen Alterungszustand eines elektrischen Energiespeichers (1) eines Kraftfahrzeugs beeinflussenden Betriebsparameters des elektrischen Energiespeichers, umfassend die folgenden Schritte:
a) Bestimmen eines tatsächlichen Alterungszustands (SOH_{Ist}) des elektrischen Energiespeichers;
b) Bestimmen eines Soll-Alterungszustands (SOH_{Soll}) des elektrischen Energiespeichers; und
c1) Anpassen eines für den mindestens einen Betriebsparameter zugelassenen Betriebsparameterbereichs, wenn ein Vergleich des tatsächlichen Alterungszustands (SOH_{Ist}) mit dem Soll-Alterungszustand (SOH_{Soll}) ergibt, dass der tatsächliche Alterungszustand eine erhöhte Alterung im Vergleich zum Soll-Alterungszustand (SOH_{Soll}) anzeigt, wobei der Betriebsparameterbereich so angepasst wird, dass der Betrieb des elektrischen Energiespeichers (1) innerhalb des angepassten Betriebsparameterbereichs mit verringerter Alterungsgeschwindigkeit erfolgt; und
c2) Anpassen des für den mindestens einen Betriebsparameter zugelassenen Betriebsparameterbereichs, wenn ein Vergleich des tatsächlichen Alterungszustands (SOHₗₛₜ) mit dem Soll-Alterungszustand (SOH_{Soll}) ergibt, dass der tatsächliche Alterungszustand eine verringerte Alterung im Vergleich zum Soll-Alterungszustand (SOH_{Soll}) anzeigt, wobei der Betriebsparameterbereich so angepasst wird, dass der Betrieb des elektrischen Energiespeichers (1) innerhalb des angepassten Betriebsparameterbereichs mit erhöhter Alterungsgeschwindigkeit erfolgt;
**gekennzeichnet durch** ein
d) Bestimmen einer Restlebensdauer oder Restnutzungsstrecke des elektrischen Energiespeichers (1), bis dieser voraussichtlich einen "End of Life"-Alterungszustand erreicht, wobei das Anpassen des für den mindestens einen Betriebsparameter zugelassenen Betriebsparameterbereichs in Abhängigkeit von der bestimmten Restlebensdauer oder Restnutzungsstrecke (RMD) erfolgt, derart, dass die Anpassung mit abnehmender verbleibender Restlebensdauer oder Restnutzungsstrecke (RMD) größer ist.

2. Verfahren nach Anspruch 1, **dadurch gekennzeichnet, dass** die Anpassung des für den mindestens einen Betriebsparameter zugelassenen Betriebsparameterbereichs nur dann erfolgt, wenn ein Differenzbetrag aus tatsächlichem Alterungszustand (SO-H_{Ist}) und Soll-Alterungszustand (SOH_{Soll}) einen vorbestimmten Schwellenwert überschreitet.

3. Verfahren nach einem der vorhergehenden Ansprüche, **dadurch gekennzeichnet,**
(a) dass der mindestens eine Betriebsparameter ein zulässiges Ladezustandsfenster des elektrischen Energiespeichers (1) angibt, das eine zulässige untere Ladezustandsgrenze (SOC_{Min}) und eine zulässige obere Ladungszustandsgrenze (SOC_{Max}) festlegt; und
(b1) dass die zulässige untere Ladezustandsgrenze (SOC_{Min}) angehoben und/oder die zulässige obere Ladungszustandsgrenze (SOC_{Max}) abgesenkt wird, wenn der tatsächliche Alterungszustand eine erhöhte Alterung im Vergleich zum Soll-Alterungszustand (SOH_{Soll}) anzeigt und/oder
(b2) dass die zulässige untere Ladezustandsgrenze (SOC_{Min}) abgesenkt und/oder die zulässige obere Ladungszustandsgrenze (SOC_{Max}) erhöht wird, wenn der tatsächliche Alterungszustand eine verringerte Alterung im Vergleich zum Soll-Alterungszustand (SOH_{Soll}) anzeigt.

4. Verfahren nach einem der vorhergehenden Ansprüche, **dadurch gekennzeichnet,**
(a) dass der mindestens eine Betriebsparameter einen maximal zulässigen Lade-und/oder Entladestrom und/oder einen maximal zulässigen Lade- und/oder Entladestrom für ein parametrierbares Zeitintervall angibt; und
(b1) dass der maximal zulässige Lade- und/oder Entladestrom abgesenkt wird, wenn der tatsächliche Alterungszustand (SOH_{Ist}) eine erhöhte Alterung im Vergleich zum Soll-Alterungszustand (SOH_{Soll}) anzeigt; und/oder
(b2) dass der maximal zulässige Lade- und/oder Entladestrom erhöht wird, wenn der tatsächliche Alterungszustand (SOH_{Ist}) eine verringerte Alterung im Vergleich zum Soll-Alterungszustand (SOH_{Soll}) anzeigt.

5. Verfahren nach einem der vorhergehenden Ansprüche, **dadurch gekennzeichnet,**
(a) dass der mindestens eine Betriebsparameter eine obere Temperaturgrenze für die maximal zulässige Temperatur des Energiespeichers angibt; und
(b1) dass die obere Temperaturgrenze abgesenkt wird, wenn der tatsächliche Alterungszustand eine erhöhte Alterung im Vergleich zum Soll-Alterungszustand (SOH_{Soll}) anzeigt; und/oder
(b2) dass die obere Temperaurgrenze erhöht wird, wenn der tatsächliche Alterungszustand eine verringerte Alterung im Vergleich zum Soll-Alterungszustand (SOH_{Soll}) anzeigt.

6. Verfahren nach einem der vorhergehenden Ansprüche, **dadurch gekennzeichnet, dass** der Soll-Alterungszustand (SOH_{Soll}) mittels einer hinterlegten Kennlinie bestimmt wird, die einen Soll-Alterungszustand (SOH_{Soll}) in Abhängigkeit von einem ersten Parameter, der ein Maß für eine Dauer seit der Inbetriebnahme des elektrischen Energiespeichers ist, und/oder von einem zweiten Parameter, der ein Maß für den bisherigen Energiedurchsatz des elektrischen Energiespeichers (1) ist, angibt.

7. Verfahren nach einem der vorhergehenden Ansprüche, **dadurch gekennzeichnet, dass** anhand von Daten, die einen bisherigen zeitlichen Verlauf des tatsächlichen Alterungszustands (SOHₗₛₜ) des Energiespeichers angeben, der sich durch Anpassung der Betriebsparameterbereiche wenigstens zweier Betriebsparameter ergeben hat, derjenige Betriebsparameter ermittelt wird, der durch Anpassung seines Betriebsparameterbereichs am schnellsten eine Annäherung des tatsächlichen Alterungszustands (SOHₗₛₜ) hin zum Soll-Alterungszustand (SOH_{Soll}) ermöglicht hat.

8. Verfahren nach einem der vorhergehenden Ansprüche, **dadurch gekennzeichnet, dass** bei einer Abweichung des tatsächlichen Alterungszustands (SOH_{Ist}) vom Soll-Alterungszustands (SOH_{Soll}) des elektrischen Energiespeichers ein zukünftiger Verlauf des tatsächlichen Alterungszustands (SOH_{Ist}) auf Basis von gespeicherten Nutzungsdaten des elektrischen Energiespeichers vorhergesagt wird, wobei die Anpassung des für den mindestens einen Betriebsparameter zugelassenen Betriebsparameterbereichs in Abhängigkeit des vorhergesagten zukünftigen Verlaufs des tatsächlichen Alterungszustands (SOH_{Ist}) erfolgt.

9. Verfahren nach einem der vorhergehenden Ansprüche, **dadurch gekennzeichnet, dass** das Anpassen eines für den mindestens einen Betriebsparameter zugelassenen Betriebsparameterbereichs durch eine Simulation erfolgt, die eine Entwicklung des tatsächlichen Alterungszustands (SOH_{Ist}) für unterschiedliche Anpassungen der Betriebsparameterbereiche eines Betriebsparameters und/oder für eine Anpassung der Betriebsparameterbereiche unterschiedlicher Betriebsparameter des elektrischen Energiespeichers unter Verwendung eines Lebensdauerenergiespeichermodells und eines vorgegebenen Lebensdauernutzungsprofils des Energiespeichers simuliert, wobei mittels der Simulation diejenige Betriebsparameterbereichsanpassung ermittelt wird, die eine optimale Annäherung an den Soll-Alterungszustands (SOH_{Soll}) ermöglicht.

10. Steuervorrichtung (2, 8) zur Steuerung und/oder Regelung mindestens eines einen Alterungszustand eines elektrischen Energiespeichers (1) eines Kraftfahrzeugs beeinflussenden Betriebsparameters des elektrischen Energiespeichers (1), die ausgeführt ist, das Verfahren nach einem der Ansprüche 1 bis 9 durchzuführen, wobei die Vorrichtung umfasst:
a) eine erste Steuereinrichtung (8) zur Steuerung der Antriebsstrangkomponenten des Kraftfahrzeugs; und
b) eine zweite Steuereinrichtung (2) zur Steuerung des elektrischen Energiespeichers (1),
wobei die erste Steuereinrichtung (8) ausgeführt ist,
a1) den Soll-Alterungszustand (SOH_{Soll}) des elektrischen Energiespeichers (1) zu bestimmen und an die zweite Steuereinrichtung (2) zu übertragen;
a2) einen angepassten Betriebsparameterbereich des wenigstens einen Betriebsparameters des elektrischen Energiespeichers (1) von der zweiten Steuereinrichtung (2) zu empfangen, und
a3) unter Berücksichtigung des empfangenen Betriebsparameterbereichs wenigstens eines Betriebsparameters des elektrischen Energiespeichers (1) einen Inverter (7) des elektrischen Energiespeichers (1) anzusteuern;
und wobei die zweite Steuereinrichtung (2) ausgeführt ist,
b1) den tatsächlichen Alterungszustand (SOH_{Ist}) des elektrischen Energiespeichers (1) zu bestimmen,
b2) den bestimmten Soll-Alterungszustand (SOH_{Soll}) von der ersten Steuereinrichtung (8) zu empfangen und den zugelassenen Betriebsparameterbereich für den mindestens einen Betriebsparameter anzupassen und an die erste Steuereinrichtung (8) zu übertragen.

11. Kraftfahrzeug, vorzugsweise Nutzfahrzeug, mit einer Steuervorrichtung (2, 8) nach Anspruch 10.

## Claims

1. A method for the open-loop and/or closed-loop control of at least one operating parameter of an electrical energy store (1) of a motor vehicle, which operating parameter influences a state of health of the electrical energy store, said method comprising the following steps:
a) determining an actual state of health (SOH_{Actual}) of the electrical energy store;
b) determining a desired state of health (SOH_{Desired}) of the electrical energy store; and
c1) adjusting an operating parameter range that is permitted for the at least one operating parameter if a comparison of the actual state of health (SOH_{Actual}) with the desired state of health (SOH_{Desired}) reveals that the actual state of health shows increased ageing in comparison to the desired state of health (SOH_{Desired}), wherein the operating parameter range is adjusted so that the electrical energy store (1) is operated at a reduced rate of ageing within the adjusted operating parameter range; and
c2) adjusting the operating parameter range that is permitted for the at least one operating parameter if a comparison of the actual state of health (SOH_{Actual}) with the desired state of health (SOH_{Desired}) reveals that the actual state of health shows reduced ageing in comparison to the desired state of health (SOH_{Desired}) , wherein the operating parameter range is adjusted so that the electrical energy store (1) is operated at an increased rate of ageing within the adjusted operating parameter range;
**characterized by**
d) determining a remaining service life or remaining mission distance of the electrical energy store (1) until said electrical energy store is expected to reach an "end-of-life" state of health, wherein the operating parameter range that is permitted for the at least one operating parameter is adjusted on the basis of the determined remaining service life or remaining mission distance (RMD) such that the adjustment is greater as the remaining service life or remaining mission distance (RMD) decreases.

2. The method according to Claim 1, **characterized in that** the operating parameter range that is permitted for the at least one operating parameter is adjusted only if a difference between the actual state of health (SOH_{Actual}) and the desired state of health (SOH_{Desired}) exceeds a predetermined threshold value.

3. The method according to either one of the preceding claims, **characterized**
(a) in that the at least one operating parameter indicates a permissible state-of-charge window of the electrical energy store (1), which defines a permissible lower state-of-charge limit (SOC_{Min}) and a permissible upper state-of-charge limit (SOC_{Max}) ; and
(b1) in that the permissible lower state-of-charge limit (SOC_{Min}) is raised and/or the permissible upper state-of-charge limit (SOC_{Max}) is lowered if the actual state of health shows increased ageing in comparison to the desired state of health (SOH_{Desired}) and/or
(b2) in that the permissible lower state-of-charge limit (SOC_{Min}) is lowered and/or the permissible upper state-of-charge limit (SOC_{Max}) is raised if the actual state of health shows reduced ageing in comparison to the desired state of health (SOH_{Desired}).

4. The method according to one of the preceding claims, **characterized**
(a) in that the at least one operating parameter indicates a maximum permissible charging and/or discharging current and/or a maximum permissible charging and/or discharging current for a parametrizable time interval; and
(b1) in that the maximum permissible charging and/or discharging current is reduced if the actual state of health (SOH_{Actual}) shows increased ageing in comparison to the desired state of health (SOH_{Desired}) ; and/or
(b2) in that the maximum permissible charging and/or discharging current is increased if the actual state of health (SOH_{Actual}) shows reduced ageing in comparison to the desired state of health (SOH_{Desired}).

5. The method according to one of the preceding claims, **characterized**
(a) in that the at least one operating parameter indicates an upper temperature limit for the maximum permissible temperature of the energy store; and (b1) in that the upper temperature limit is lowered if the actual state of health shows increased ageing in comparison to the desired state of health (SOH_{Desired}) ; and/or
(b2) in that the upper temperature limit is raised if the actual state of health shows reduced ageing in comparison to the desired state of health (SOH_{Desired}).

6. The method according to one of the preceding claims, **characterized in that** the desired state of health (SOH_{Desired}) is determined by means of a stored characteristic curve that indicates a desired state of health (SOH_{Desired}) as a function of a first parameter, which is a measure of a period since the start-up of the electrical energy store, and/or as a function of a second parameter, which is a measure of the energy throughput to date of the electrical energy store (1).

7. The method according to one of the preceding claims, **characterized in that** data indicating a temporal profile to date of the actual state of health (SOH_{Actual}) of the energy store that has resulted from the adjustment of the operating parameter ranges of at least two operating parameters are used to determine the operating parameter that has allowed, by adjustment of its operating parameter range, the fastest approximation of the actual state of health (SOH_{Actual}) towards the desired state of health (SOH_{Desired}) .

8. The method according to one of the preceding claims, **characterized in that** if the actual state of health (SOH_{Actual}) deviates from the desired state of health (SOH_{Desired}) of the electrical energy store, a future profile of the actual state of health (SOH_{Actual}) is predicted on the basis of stored usage data of the electrical energy store, wherein the operating parameter range that is permitted for the at least one operating parameter is adjusted on the basis of the predicted future profile of the actual state of health (SOH_{Actual}).

9. The method according to one of the preceding claims, **characterized in that** an operating parameter range that is permitted for the at least one operating parameter is adjusted by means of a simulation that simulates a development of the actual state of health (SOH_{Actual}) for different adjustments of the operating parameter ranges of an operating parameter and/or for an adjustment of the operating parameter ranges of different operating parameters of the electrical energy store by using a service life energy store model and a predetermined service life usage profile of the energy store, wherein the operating parameter range adjustment that allows optimal approximation to the desired state of health (SOH_{Desired}) is determined by means of the simulation.

10. A control apparatus (2, 8) for the open-loop and/or closed-loop control of at least one operating parameter of an electrical energy store (1) of a motor vehicle, which operating parameter influences a state of health of the electrical energy store (1), said control apparatus being embodied so as to carry out the method according to any one of Claims 1 to 9, wherein the apparatus comprises:
a) a first control device (8) for controlling the drivetrain components of the motor vehicle; and
b) a second control device (2) for controlling the electrical energy store (1),
wherein the first control device (8) is embodied so as to
a1) determine the desired state of health (SOH_{Desired}) of the electrical energy store (1) and transmit same to the second control device (2);
a2) receive an adjusted operating parameter range of the at least one operating parameter of the electrical energy store (1) from the second control device (2), and
a3) control an inverter (7) of the electrical energy store (1), taking into account the received operating parameter range of at least one operating parameter of the electrical energy store (1);
and wherein the second control device (2) is embodied so as to
b1) determine the actual state of health (SOH_{Actual}) of the electrical energy store (1);
b2) receive the determined desired state of health (SOH_{Desired}) from the first control device (8) and adjust the permitted operating parameter range for the at least one operating parameter and transmit said permitted operating parameter range to the first control device (8).

11. A motor vehicle, preferably a utility vehicle, having a control apparatus (2, 8) according to Claim 10.

## Revendications

1. Procédé de commande et/ou de régulation d'au moins un paramètre de fonctionnement d'un accumulateur d'énergie électrique qui influe sur un état de vieillissement de l'accumulateur d'énergie électrique (1) d'un véhicule automobile, ledit procédé comprenant les étapes suivantes :
a) déterminer un état de vieillissement réel (SOHᵢₛₜ) de l'accumulateur d'énergie électrique ;
b) déterminer un état de vieillissement cible (SOHₛₒₗₗ) de l'accumulateur d'énergie électrique ; et
c1) adapter une plage de paramètres de fonctionnement autorisée pour l'au moins un paramètre de fonctionnement si une comparaison de l'état de vieillissement réel (SOHᵢₛₜ) à l'état de vieillissement cible (SOHₛₒₗₗ) montre que l'état de vieillissement réel indique un vieillissement accru par rapport à l'état de vieillissement cible (SOHₛₒₗₗ), la plage de paramètres de fonctionnement étant adaptée de telle sorte que le fonctionnement de l'accumulateur d'énergie électrique (1) s'effectue dans la plage de paramètres de fonctionnement adaptée avec une vitesse de vieillissement réduite ; et
c2) adapter la plage de paramètres de fonctionnement autorisée pour l'au moins un paramètre de fonctionnement si une comparaison de l'état de vieillissement réel (SOHᵢₛₜ) à l'état de vieillissement cible (SOHₛₒₗₗ) montre que l'état de vieillissement réel indique un vieillissement réduit par rapport à l'état de vieillissement cible (SOHₛₒₗₗ), la plage de paramètres de fonctionnement étant adaptée de telle sorte que le fonctionnement de l'accumulateur d'énergie électrique (1) s'effectue dans la plage de paramètres de fonctionnement adaptée avec une vitesse de vieillissement accrue ; **caractérisé par**
d) déterminer une durée de vie restante ou une étendue d'utilisation restante de l'accumulateur d'énergie électrique (1) jusqu'à ce qu'il soit supposé atteindre un état de vieillissement « End of life », l'adaptation de la plage de paramètres de fonctionnement autorisée pour l'au moins un paramètre de fonctionnement s'effectuant en fonction de la durée de vie restante ou de l'étendue d'utilisation restante (RMD) déterminée, de telle sorte que l'adaptation est d'autant plus grande que la durée de vie restante ou l'étendue d'utilisation restante (RMD) diminue.

2. Procédé selon la revendication 1, **caractérisé en ce que** l'adaptation de la plage de paramètres de fonctionnement autorisée pour l'au moins un paramètre de fonctionnement n'est effectuée que si une différence entre l'état de vieillissement réel (SOHᵢₛₜ) et l'état de vieillissement cible (SOHₛₒₗₗ) dépasse une valeur seuil prédéterminée.

3. Procédé selon l'une des revendications précédentes, **caractérisé en ce que**
(a) l'au moins un paramètre de fonctionnement indique une fenêtre d'état de charge admissible de l'accumulateur d'énergie électrique (1) qui définit une limite inférieure d'état de charge admissible (SOC_{Min}) et une limite supérieure d'état de charge admissible (SOC_{Max}) ; et
(b1) la limite inférieure d'état de charge admissible (SOC_{Min}) est augmentée et/ou la limite supérieure d'état de charge admissible (SOC_{Max}) est réduite si l'état de vieillissement réel indique un vieillissement accru par rapport à l'état de vieillissement cible (SOHₛₒₗₗ) et/ou (b2) la limite inférieure d'état de charge admissible (SOC_{Min}) est réduite et/ou la limite supérieure d'état de charge admissible (SOC_{Max}) est augmentée si l'état de vieillissement réel indique un vieillissement réduit par rapport à l'état de vieillissement cible (SOHₛₒₗₗ).

4. Procédé selon l'une des revendications précédentes, **caractérisé en ce que**
(a) l'au moins un paramètre de fonctionnement spécifie un courant de charge et/ou de décharge maximal admissible et/ou un courant de charge et/ou de décharge maximal admissible pour un intervalle de temps paramétrable ; et
(b1) le courant de charge et/ou de décharge maximal admissible est réduit si l'état de vieillissement réel (SOHᵢₛₜ) indique un vieillissement accru par rapport à l'état de vieillissement cible (SOHₛₒₗₗ) ; et/ou (b2) le courant de charge et/ou de décharge maximal admissible est augmenté si l'état de vieillissement réel (SOHᵢₛₜ) indique un vieillissement réduit par rapport à l'état de vieillissement cible (SOHₛₒₗₗ).

5. Procédé selon l'une des revendications précédentes, **caractérisé en ce que**
(a) l'au moins un paramètre de fonctionnement spécifie une limite supérieure de température pour la température maximale admissible de l'accumulateur d'énergie ; et
(b1) la limite de température supérieure est abaissée si l'état de vieillissement réel indique un vieillissement accru par rapport à l'état de vieillissement cible (SOHₛₒₗₗ) ; et/ou
(b2) la limite supérieure de température est augmentée si l'état de vieillissement réel indique un vieillissement réduit par rapport à l'état de vieillissement cible (SOHₛₒₗₗ) .

6. Procédé selon l'une des revendications précédentes, **caractérisé en ce que** l'état de vieillissement cible (SOHₛₒₗₗ) est déterminé au moyen d'une courbe caractéristique mémorisée qui définit un état de vieillissement cible (SOHₛₒₗₗ) en fonction d'un premier paramètre qui est une mesure d'une durée depuis la mise en service de l'accumulateur d'énergie électrique, et/ou d'un deuxième paramètre qui est une mesure du débit d'énergie précédent de l'accumulateur d'énergie électrique (1).

7. Procédé selon l'une des revendications précédentes, **caractérisé en ce que**, à partir de données qui indiquent une variation temporelle antérieure de l'état de vieillissement réel (SOHᵢₛₜ) de l'accumulateur d'énergie qui a résulté de l'adaptation des plages de paramètres de fonctionnement d'au moins deux paramètres de fonctionnement, on détermine le paramètre de fonctionnement qui a permis de rapprocher le plus rapidement possible l'état de vieillissement réel (SOHᵢₛₜ) de l'état de vieillissement cible (SOHₛₒₗₗ) par adaptation de sa plage de paramètres de fonctionnement.

8. Procédé selon l'une des revendications précédentes, **caractérisé en ce que**, lorsque l'état de vieillissement réel (SOHᵢₛₜ) s'écarte de l'état de vieillissement cible (SOHₛₒₗₗ) de l'accumulateur d'énergie électrique, une variation future de l'état de vieillissement réel (SOHᵢₛₜ) est prédite sur la base de données d'utilisation mémorisées de l'accumulateur d'énergie électrique, l'adaptation de la plage de paramètres de fonctionnement autorisée pour l'au moins un paramètre de fonctionnement est effectuée en fonction de la variation future prévue de l'état de vieillissement réel (SOHᵢₛₜ).

9. Procédé selon l'une des revendications précédentes, **caractérisé en ce que** l'adaptation d'une plage de paramètres de fonctionnement autorisée pour l'au moins un paramètre de fonctionnement est effectuée au moyen d'une simulation qui simule un développement de l'état de vieillissement réel (SOHᵢₛₜ) pour différentes adaptations des plages d'un paramètre de fonctionnement et/ou pour une adaptation des plages de différents paramètres de fonctionnement l'accumulateur d'énergie électrique à l'aide d'un modèle d'accumulateur d'énergie à durée de vie et d'un profil d'utilisation de durée de vie spécifié de l'accumulateur d'énergie, la simulation permettant de déterminer l'adaptation de plage de paramètres de fonctionnement qui permet une approximation optimale de l'état de vieillissement cible (SOHₛₒₗₗ).

10. Dispositif de commande (2, 8) destiné à commander et/ou réguler au moins un paramètre de fonctionnement de l'accumulateur d'énergie électrique (1) qui influe sur un état de vieillissement d'un accumulateur d'énergie électrique (1) d'un véhicule automobile et qui est conçu pour mette en œuvre le procédé selon l'une des revendications 1 à 9, le dispositif comprenant :
a) un premier moyen de commande (8) destiné à commander les composants de la chaîne cinématique du véhicule automobile ; et
b) un deuxième moyen de commande (2) destiné à commander l'accumulateur d'énergie électrique (1),
le premier moyen de commande (8) étant conçu pour
a1) déterminer l'état de vieillissement cible (SOHₛₒₗₗ) de l'accumulateur d'énergie électrique (1) et le transmettre au deuxième moyen de commande (2) ;
a2) recevoir une plage de paramètres de fonctionnement adaptée de l'au moins un paramètre de fonctionnement de l'accumulateur d'énergie électrique (1) du deuxième moyen de commande (2), et
a3) commander un onduleur (7) de l'accumulateur d'énergie électrique (1) avec prise en compte de la plage de paramètres de fonctionnement reçue d'au moins un paramètre de fonctionnement de l'accumulateur d'énergie électrique (1) ;
et le deuxième moyen de commande (2) étant conçu pour
b1) déterminer l'état de vieillissement réel (SOHᵢₛₜ) de l'accumulateur d'énergie électrique (1),
b2) recevoir l'état de vieillissement cible déterminé (SOHₛₒₗₗ) du premier moyen de commande (8) et adapter la plage de paramètres de fonctionnement autorisée pour l'au moins un paramètre de fonctionnement et la transmettre au premier moyen de commande (8).

11. Véhicule automobile, de préférence véhicule utilitaire, comprenant un dispositif de commande (2, 8) selon la revendication 10.
